# EUROPEAN PATENT APPLICATION

(11) **EP 1 522 565 A2**
(43) Date of publication of application: **13.04.2005**
(21) Application number: 04023717.4
(22) Date of filing: 05.10.2004
(51) Int. Cl.: C09G 1/02, C09K 3/14, C23F 3/00, H01L 21/321

(54) **Polishing composition and use thereof**

(30) Priority: 10.10.2003 US 683553
(71) Applicant: AIR PRODUCTS AND CHEMICALS, INC., Allentown, PA 18195-1501 (US)
(72) Inventor: Tamboli, Dnyanesh Chandrakant, Dublin, OH 43017 (US); Hymes, Stephen W., Austin, TX 78767 (US); Banerjee, Gautam, Dublin, OH 43017 (US)
(74) Representative: Schwabe - Sandmair - Marx

(57) **Abstract**

An acidic aqueous slurry composition comprising silica abrasive particles, an oxidizer, a quaternary ammonium hydroxide; and acid having a maximum pKa of about 2.5; and water is provided along with its use for polishing.

## Description

### TECHNICAL FIELD

The present invention relates to an aqueous chemical formulation that is especially useful for polishing or planarizing a surface. The present invention is especially useful for polishing or planarizing metals such as those used as interconnect structures in integrated circuit devices such as semiconductor wafers containing copper damascene and dual damascene feature.

### BACKGROUND OF THE INVENTION

On VLSI and ULSI semiconductor chips, A1 and alloys of A1 are used for conventional chip interconnect/wiring material. However, more recently copper and alloys of copper have been developed as chip interconnects material. The use of copper and copper alloys results in improved device performance when compared to A1 and its alloys

By way of example, various new memory technologies are currently under development. Particularly important are the non-volatile memory devices which would allow the devices to retain the memory even after the power is switched-off. Magnetic Random Access Memory (MRAM) is one of the most promising technologies in this regard. MRAM offers a great potential for high density, high speed and low power consumption.

MRAM devices are based on a phenomenon known as Giant Magneto Resistance (GMR). GMR is exhibited when an electric field is applied across two layers of a ferromagnetic layers separated by a thin non-magnetic layer. The electrical conductivity across these layers depends on the orientation of the magnetic field of the two ferromagnetic layers relative to each other. When the orientations are parallel, the electrical conductivity is highest; and when they are anti-parallel, the conductivity is the lowest. GMR refers to this large difference in the electrical conductivity depending on the orientation of the magnetic field.

A MRAM device employs multiple metallization layers including barrier layers (typically Ta and/or TaN), copper, ferromagnetic layers (typically a Fe-Ni alloy) and a metal (from group 4d and 5d of the periodic table; most commonly ruthenium, rhodium, iridium and rhenium), which exhibits inter-layer exchange coupling with the ferromagnetic material. The damascene process coupled with chemical mechanical planarization (CMP) is used to define the MRAM structures. This process which is in concept similar to that used with the copper interconnect formation in typical semiconductor fabrication is also used. The Damascene process typically involves blanket depositing the metallic layers over a layer of dielectric which has trenched features etched into its surface. The deposited metal fills the pre-etched gaps or trenches in the dielectric, and leaves a metal overabundance on the surface of the wafer which must be removed. Once the metal overabundance has been removed, an inlaid metal wiring structure is left on the surface of the wafer. The removal of the metal is achieved by chemical mechanical polishing (CMP).

Use of multiple metallization layers which differ greatly in chemical and mechanical properties pose a great challenge for chemical mechanical planarization. Ideally it would be desirable that a single slurry is able to remove all these layers without compromising planarity or defectivity related to corrosion.

In the practice of chemical mechanical polishing, several critical requirements must be met in terms of the slurry component properties. For instance, retention of colloidal stability of the slurry components during storage, after blending, and just prior to use is an important specification. In practice, polishing slurries are typically two component systems. The abrasive component contains the abrasive, and may also contain organic acid(s), chelate(s), surfactant(s), corrosion inhibitor(s), and other additives. The second component is the oxidizer. The two components and typically keep separate until time of use due to the fact that the oxidizer would react with the other components over time, placing a limitation on the shelf life of the product. After blending and just prior to use, it is important that the blended slurry retains its colloidal stability and polish performance for several days. This is because after blending, the blended slurry may sit in a primary tank and be delivered to the polisher over the course of several hours to several days. Hence the pot life of the blended slurry is a key specification for a commercial product.

### BRIEF SUMMARY OF THE INVENTION

The present invention provides slurry compositions that are suitable for CMP. Compositions of the present invention make possible effective removal of metallic layer including those used in MRAM devices as discussed above in a minimum number of steps while assuring good planarity, absence of corrosion and excellent colloidal stability for the abrasive particles in the slurry.

The slurry compositions of the present invention comprise:
A. about 0.0 % by weight to about 50% by weight of abrasive particles;
B. about 0.01% to about 50% by weight of an oxidizer;
C. at least about 100 ppm of quaternary ammonium hydroxide;
D. an acid having a pKa of about 2.5 or lower in an amount sufficient to provide an acidic pH;
and F. water.

A further aspect of the present invention relates to a method for polishing or planarizing a substrate which comprises contacting the substrate with the above disclosed composition and polishing or planarizing the substrate by chemical-mechanical polishing.

A still further aspect of the present invention relates to a method for fabrication semiconductor integrated circuits comprising forming circuits on the surface of a semiconductor wafer by photolithographic and plating processes, polishing or planarizirig the circuitry by contacting the semiconductor wafer with the above disclosed composition and polishing and planarizing the circuitry by chemical-mechanical polishing.

Still other objects and advantages of the present invention will become readily apparent to those skilled in the art from the following detailed description, wherein it is shown and described preferred embodiments of the invention, simply by way of illustration of the best mode contemplated of carrying out the invention. As will be realized the invention is capable of other and different embodiments, and its several details are capable of modifications in various obvious respects without departing from the invention. Accordingly, the description is to be regarded as illustrative in nature and not as restrictive.

### SUMMARY OF FIGURES

The figure shows electrochemical polarization of difference films

### Best and Various Modes for Carrying Out Invention

All percentages by weight (wt/wt) are based on the total weight of the composition.

The compositions of the present invention contain abrasive particles such as silica, alumina, zirconia, titania, ceria and the like with silica being most typical.

The abrasive particles typically have particle sizes of about 10 to about 1000 nanometers and more typically about 10 to about 200 nanometers.

The concentration of the abrasive particles is typically about 0.01 % to about 50%, more typically about 0.1% to about 20% of weight and even more typically about 5% to about 15% by weight.

The compositions of the present invention also contain an oxidizing agent. Suitable oxidizing agents include oxidizing metal salts, oxidizing metal complexes, nonmetallic oxidizing acids such as per acetic and periodic acids, iron salts such as nitrates, sulfates EDTA, citrates, potassium ferricyanide and the like, hydrogen peroxide, aluminum salts, sodium salts, potassium salts, ammonium salts, quaternary ammonium salts, phosphonium salts, or other cationic salts of peroxides, chlorates, perchlorates, nitrates, permanganates, persulfates and mixtures thereof.

The preferred oxidizing agent is hydrogen peroxide. The oxidizing agent(s) are typically present in the composition in amounts of about 0.01% wt. to about 50 wt. %, more typically about 0.05 wt. % to about 5 wt. % and even more typically about 0.1 wt.% to about 1 wt.%.

The compositions of the present invention also contain a quaternary ammonium hydroxide. The quaternary ammonium hydroxide improves the shelf life of the slurry by the way of increasing colloidal stability. Quaternary ammonium hydroxide bases have been found to improve the colloidal stability of silica particles in the acidic pH environment of the compositions of the present invention.

The quaternary ammonium compound can be represented by the formula [NR₁R₂R₃R₄]OH wherein each of R₁,R₂, R₃, and R₄ individually is an alkyl group.

The term "alkyl" refers to straight or branched chain unsubstantiated hydrocarbon groups of 1 to 20 carbon atoms, preferably 1 to 8 carbon atoms. The expression "lower alkyl" refers to alkyl groups of 1 to 4 carbon atoms. Examples of suitable alkyl groups include methyl, ethyl, proplyl and butyl. Typical quaternary ammonium hydroxides are tetraalkylammonium and aryltrialkylammonium hydroxides such as tetramethylammonium hydroxide, tetraethylammonium hydroxide, tetrapropylammonium hydroxide, tetrabutylammonium hydroxide, ethyltrimethylammonium hydroxide, diethyldimethylammonium hydroxide and benzyltrimethylammonium hydroxide.

Typical concentrations of quaternary ammonium hydroxide bases is about 500 ppm or higher, more typically about 1000 ppm or higher and even more typically 2500 ppm or higher with the maximum typically being about 1.5%.

The compositions of the present invention also comprise at least one acid having a pKa of 2.5 or lower and more typically about 1.5 or lower. Typical acids are inorganic acids such as phosphoric acid, nitric acid, sulfuric and hydrochloric acid; and organic carboxylic acids such as oxalic acid, malonic acid, and citric acid; with phosphoric acid being the most typical. The amount of acid to provide an acidic pH for the slurry, typically above about 1.5 and more typically about 2 or above, and even more typically a maximum pH of about 5. A pH of above 1.5 makes it possible to reduce corrosion related issues. In the case of phosphoric acid, the concentration is about 0.05% to about 5% by weight and more typically about 0.1% by weight to about 1% by weight. Compositions may optionally also contain acids having pKa greater than 2.5 in combination to the acids with pKa of less than 2.5.

The water is typically present in amounts of about 70% to about 95% by weight, more typically about 80% to about 90% by weight, and even more typically about 85% by weight in the slurry.

The compositions of the present invention can optionally also include a copper corrosion inhibitor. The relative amounts of copper corrosion inhibitor, when present, is typically about 100 ppm (0.01%) to about 15,000 ppm (1.5%), and more typically about 1,000 ppm (0.1%) to about 10,000 ppm (1 %) in the slurry. A typical corrosion inhibitor is benzotriazole

Examples of corrosion inhibitors are aromatic hydroxyl compounds, acetylenic alcohols, carboxyl group containing organic compounds and anhydrides thereof, imidazoles and triazole compounds.

Exemplary aromatic hydroxyl compounds include phenol, cresol, xylenol, pyrocatechol, resorcinol, hydroquinone, pyrogallol, 1.2.4-benzenetriol, salicyl alcohol, p-hydroxybenzy] alcohol, o-hydroxybenzyl alcohol, p-hydroxyphenethyl alcohol, p-aminophenol, m-aminophenol, diaminophenol, amino resorcinol, p-hydroxybenzoic acid, o-hydroxybenzoic acid 2,4-dihydroxybenzoic acid, 2-5-dihydroxybenzoic acid, 3,4-dihydroxybenzoic acid and 3,5-dihydroxybenzoic acid.

Exemplary acetylenic alcohols include 2-butyne-1,4-diol, 3,5-dimethyl-1-hexyn-3-ol, 2 methyl-3-butyn-2-ol, 3-methyl-1-pentyn-3-ol, 3,6-dimethyl-4-octyn-3,6-diol, 2,4- 7,9-tetramethyl-5-decyne-4,7-diol and 2,5-dimethyl-3-hexyne 2,5-diol.

Exemplary carboxyl group containing organic compounds and anhydrides thereof include formic acid, acetic acid, propionic acid, butyric acid, isobutyric acid, oxalic acid, malonic acid, succinic acid, glutaric acid, maleic acid, fumaric acid, benzoic acid, phthalic acid, 1,2,3-benzenetricarboxylic acid, glycolic acid, lactic acid, malic acid citric acid, acetic anhydride and salicylic acid.

Exemplary triazole compounds include benzotriazole, 1, 2, 4-triazole o-tolyltriazole, m-tolyltriazole, p-tolyltriazole, carboxybenzotriazole, 1-hydroxybenzotriazole, nitrobenzotriazole and dihydroxypropylbenzotriazole.

The compositions of the present invention also contain a surface active agent. Suitable surface active agents include anionic, cationic, nonionic and zwitterionic compounds. Examples of some surfactants for use in the present invention are disclosed in, for example, Kirk-Othmer, *Encyclopedia of Chemical Terminology, 3rd Edition,* Vol. 22 (John Wiley & Sons, 1983), Sislet & Wood, *Encyclopedia of Surface Active Agents* (Chemical Publishing Co., Inc. 1964), McCutcheon's *Emulsifiers & Detergents, North American and International Edition* (McCutcheon Division, The MC Publishing Co., 1991), Ash, *The Condensed Encyclopedia of Surfactants* (chemical Publishing Co., Inc., 1989), Ash, *What Every Chemical Technologist Wants to Know About* ... *Emulsifiers and Wetting Agents,* Vol. 1 (Chemical Publishing Co., Inc., 1988), Tadros, *Surfactants* (Academic Press, 1984), Napper, *Polymeric Stabilization of Colloidal Dispersion* (Academic Press, 1983) and Rosen, *Surfactants & Interfacial Phenomena, 2*^{*nd*} Edition (John Wiley & sons, 1989), all of which are incorporated herein by reference.

Typical examples of suitable surface active agents are: Na-alkyl sulfates, Na-alkyl sulfonates, quarternary such as tetramethyl ammonium halides, Cetyl trimethy ammonium halides, hydroxides, nonyl ethers and combinations thereof. Preferred surface active agents are sulfates such as Na -hexyl, -heptyl, -octyl, nonyl and -lauryl sulfates with Na octyl sulfate being most preferred. Na octyl sulfate is commercially available under its trade designation of Dupanol 80 (Witco)), Standapol LF(Henkel/Cognis), Texapon 842, (Henkel), Texapon 890 (Henkel) Sulfotex OA (Henkel) and Polystep B-29 (Stephan).

The amount of surface active agent is typically about 0.1 to about 100 ml/l and more typically about 20 to about 50 ml/l.

A further feature of the present invention is that the composition even in concentrated form is relatively stable. For instance, concentrates of the composition can be provided and transported to the end user, the user can then dilute it such as about a 5:1 dilution and more typically about a 3:1 dilution by weight at the process tool for convenience and for economical reasons.
The structures treated pursuant to the present invention are typically semiconductor devices having copper interconnects (lines, plugs, vias, global and local interconnects) embedded into a dielectric material such as silicon dioxide, which may also include a capping layer, such as silicon nitride as in low k dielectric/damascene and dual damascene structures. The silicon dioxide is typically a high density plasma deposited silicon dioxide or TEOS (tetraethylorthosilicate).
The copper interconnects typically use either tantalum, tantalum nitride, or titanium or titanium nitride as a barrier or liner material between the copper and the dielectric as discussed above, the present invention finds special suitability in fabricating non-volatile memory devices.
Accordingly the present invention is suitable for polishing a semiconductor substrate comprising of (i) a ferromagnetic metal layer (ii) a metal from group 3d or 5d of the periodic table (for example ruthenium, iridium, palladium, platinum, etc.) (iii) a conducting metal (such as copper, aluminum) (iv) an associated barrier layer (for example, tantalum, tantalum nitride, titanium, titanium nitride cobalt based barrier layers and/or tungsten based barrier layers) and (iv) an associated dielectric layer (such as silicon dioxide). Examples of such applications include but not restricted to manufacturing of capacitors which have relatively high dielectric constants, formation of copper damascene interconnects (with or without involving the noble metals or the ferromagnetic materials), and processing of hard disk drives.
As such, the CMP composition contacts a variety of different materials, copper, the dielectric or capping layer, as well as the wafer backside, which is generally a thin layer of oxidized silicon as a minimum. Accordingly, the polishing composition must be selective to remove the metal as contracted to the dielectric.
The parameters of the polishing or planarizing can be determined by those skilled in the art once aware of this disclosure, without exercising undue experimentation. For instance, the rate of rotation of the polishing platen (pads) is about 20 to about 100 rpm, and the speed of the rotation of the wafer carrier is about 20 to about 100 rpm and the down force about 2 to about 10 psi. The polishing pads are those conventionally used in polishing for microelectronics.
The following non-limiting examples are presented to further illustrate the present invention:

### Example 1:

The following composition is made by missing the following components in the concentrations listed bellowed. The pH of the slurry is 2.5:

| | Concentrations in ppm |
|---|---|
| PoliEdge 2001 silica | 128571 |
| Benzotriazole | 6500 |
| Tetrabutyl ammonium hydroxide | 4000 |
| Phosphoric acid | 4488 |
| Deionized water | Balance |

To this slurry, hydrogen peroxide is added as an oxidizer to oxidize the metallic layers to be polished. Dilution for polishing is 70 parts by volume of slurry: 29 parts by volume of deionized water: 1 part by volume of 30% hydrogen peroxide.

Polishing is performed on a IPEC 472 CMP tool. The polishing parameters are:
Pressure: 3 psi
Platen Speed: 90 RPM
Carrier Speed: 30 RPM
Back-pressure: 2 psi
Slurry Flow rate: 200 ml/min
Polish Pad: k-grooved IC 1000
Polish time: 60 seconds

The removal rates of the metal films are calculated based on the changes in thickness upon polishing as measured by sheet resistance measurement technique with Prometrix RS35 tool. For the TEOS film thickness is measured by Philips SD200 ellipsometer.

The following table summarizes the removal rate data for various films on wafers with 8" diameter.

| Film | Removal Rate (RR) (A/min) |
|---|---|
| Cu | 304 |
| Ta | 1024 |
| TEOS | 1230 |
| FeNI | 2008 |
| Ru | 251 |

The data shows that the removal rates are high enough for a good industrial throughput.

### Example 2:

A 8" patterned wafer containing 9000A deep trenches patterned inside a TEOS dielectric. The trenches are filled with a metallization stack consisting of 200 A Ta/ 100A Ru/250A NiFe/100A Ru/9000A Cu. The copper film deposited on the regions outside the trenches is first removed using a copper CMP process using a slurry with Cu:Ta removal rate selectivity of more than 100. This results in a wafer with copper restricted to the trenches. The remaining wafer is still covered with the Ta/ Ru/NiFe/Ru metallization layer. The slurry described in example 1 along with the hydrogen peroxide dilution also described in example 1 is used to remove these metallic layers. CMP polish parameters except for the polish time are identical as in example 1.

The following table tabulates the dishing topography for 100 micron lines for wafers polished at different stages. This topography is measured using VEECO AFP. After the initial 45 seconds, the wafer is mostly free from all the metallic layers from the regions outside the trenches. A subsequent 45 seconds of over polish results in correction of initial high topography. This results in a very planar surface with low topography.

| | After copper CMP step | 45 second polish using slurry in Example 1 | 90 second polish using slurry in Example 1 |
|---|---|---|---|
| Center Die | 1625 | 1994 | 176 |
| Mid-Die | 1716 | 1940 | 294 |
| Edge Die | 2408 | 2397 | 786 |

Visual and microscopic examination of the polished wafers shows no corrosion defects.

### Example 3:

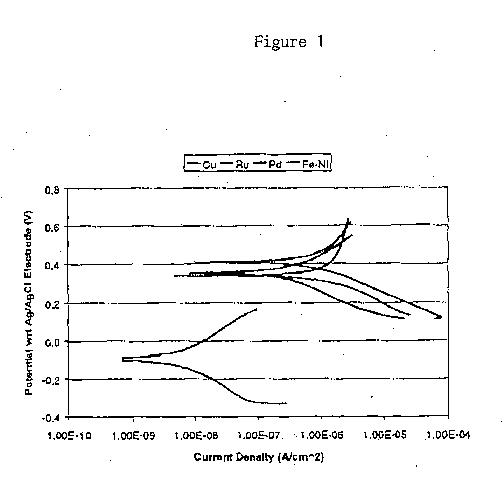

Electrochemical polarization characteristics of different film types in the slurry described in example 1 and diluted with hydrogen peroxide as shown in example 1 are measured using EG&G M263 potentiostate/galvanostat controlled by SofetcorrII corrosion software. The Scan rate is 0.25 mV/s. Figure 1 show the Electrochemical polarization curves.

The electrochemical polarization curves in the Figure show that the copper corrosion potential in the slurry mixed diluted as described in example 1 is anodic with respect to ruthenium and Fe-Ni alloy. So in case of a galvanic coupling formed between copper and any of these materials, copper will be thermodynamically favored to be protected. This would result in superior corrosion protection for copper lines/structures.

### Example 4:

Slurry samples are prepared containing 2500 ppm phosphoric acid, 500 ppm nitric acid, 10% Poliedge 2001 silica and a base to bring the pH up-to 2. Different bases used for the slurry formulations are listed in table below. The samples are aged in an oven at 50° C for 7 days. From the table it is apparent that the quaternary ammonium hydroxides such as tetrabutyl ammonium hydroxide and tetramethyl ammonium hydroxide are useful in improving the colloidal stability of the slurries in acidic pH.

| Base | pH | 7 days at 50° C |
|---|---|---|
| Ammonia | 1.99 | 88.4 |
| KOH | 1.97 | 88.5 |
| No base | 1.53 | 84.1 |
| TBAH | 1.99 | 75 |
| TMAH | 1.99 | 77.5 |

### Example 5:

The following compositions are fabricated:

| Example 1 | Composition (ppm) (grams) | | | | | | | | |
|---|---|---|---|---|---|---|---|---|---|
| | PoliEdge 2001 Silica | Benzotriazole | TBAH | Phosphoric Acid | Nitric Acid | | | pH | |
| 6A | 128571 | 5000 | 6480 | 500 | 2500 | | | 2.54 | |
| 6B | 128571 | 1000 | 6091 | 500 | 2500 | | | 2.48 | |

The balance of the above compositions is water.

These slurries are diluted with 30% hydrogen peroxide and water in the volume ratio 70 parts slurry: 29 parts water: 1 part of 30% hydrogen peroxide. Cu, Ta, TEOS, Ru and Re-Ni films on 8" wafer substrates are polished using the protocol described in Example. The following table summarizes the removal rate data.

| EXAMPLE | 6A | 6B |
|---|---|---|
| Cu | 418 | 355 |
| Ta | 1161 | 1005 |
| TEOS | 1139 | 1094 |
| Ru | 542 | 744 |
| FeNI | 1108 | 770 |

### Example 6:

The slurry described in Example 1 is mixed with de-ionized water and 30% hydrogen peroxide in different ratios. These formulations are subsequently used to polish copper films with 6" diameter. The polishing protocol is the same as described in Example 1.

As seen from this example, the copper removal rates can be tuned to whatever desired level by simply changing hydrogen peroxide amount added at the time of polishing. High copper removal rates are possible using this method which can potentially allow only compositions having the same components but differing in the relative concentration of the oxidizing agent to be used for entire polishing operation including copper overburden removal step and the barrier/sandwich removal layer step. If a tighter control of topography is needed, the same slurry can be used at two different concentrations during these stages. In copper overburden removal, peroxide concentration may be maintained high to allow high copper rates and thus high throughput. As the copper overburden is cleared, peroxide concentration may be reduced to reduce copper removal rates and thus making it possible to have a low final topography.

The foregoing description of the invention illustrates and describes the present invention. Additionally, the disclosure shows and describes only the preferred embodiments of the invention but, as mentioned above, it is to be understood that the invention is capable of use in various other combinations, modifications, and environments and is capable of changes or modifications within the scope of the inventive concept as expressed herein commensurate with the above teachings and/or the skill or knowledge of the relevant art. The embodiments described hereinabove are further intended to explain best modes known of practicing the invention and to enable others skilled in the art to utilize the invention in such, or other, embodiments and with the various modifications required by the particular applications or uses of the invention. Accordingly, the description is not intended to limit the invention to the form disclosed herein. Also, it is intended that the appended claims be construed to include alternative embodiments. All publications and patent applications cited in this specification are herein incorporated by reference as if each individual publication or patent application were specifically and individually indicated to be incorporated by reference.

## Claims

1. An aqueous slurry composition which comprises:
A. about 0.01 % by weight to about 50 % by weight of abrasive particles;
B. about 0.01 % to about 50 % by weight of an oxidizer;
C. at least about 500 ppm of a quaternary ammonium hydroxide;
D. an acid having a pKa of about 2.5 or lower in a sufficient amount to provide an acidic pH; and
E. water.

2. The composition of claim 1 wherein the amount of the abrasive particles is about 1 % to about 20 % by weight, preferably about 5 % to about 15 % by weight based on the total weight of the composition.

3. The composition of claim 1 wherein the abrasive particles comprise silica particles.

4. The composition of claim 1 wherein the oxidizer comprises hydrogen peroxide.

5. The composition of claim 1 wherein the amount of oxidizer is about 0.05 at % to about 5 wt.-%, preferably about 0.1 wt.-% to about 1 wt.-%, based on the total weight of the composition.

6. The composition of claim 1 wherein the quaternary ammonium hydroxide is represented by the formula
[NR₁R₂R₃R₄]⁻ OH
wherein each of R₁, R₂, R₃ and R₄ individually is an alkyl group of 1 to 20 carbon atoms.

7. The composition of claim 6 wherein the alkyl group contains 1 to 4 carbon atoms.

8. The composition of claim 1 wherein the quaternary ammonium hydroxide comprises tetramethyl ammonium hydroxide or tetrabutyl ammonium hydroxide.

9. The composition of claim 1 wherein the amount of quaternary ammonium hydroxide is about 1000 ppm or higher, preferably about 2500 ppm or higher, based on the total weight of the composition.

10. The composition of claim 1 wherein the acid comprises phosphoric acid.

11. The composition of claim 1 wherein the pH is at least about 1.5, preferably about 1.5 to 5.

12. The composition of claim 1 wherein the pH is at least about 2.

13. The composition of claim 1 which further comprises a corrosion inhibitor.

14. The composition of claim 13 wherein the corrosion inhibitor comprises benzotriazole.

15. The composition of claim 1 which further comprises a surface active agent.

16. A method for polishing a metal which comprises providing on the metal an aqueous slurry composition as defined in one of claims 1 to 15; and contacting the metal with a polishing pad.

17. A process for fabricating semiconductor integrated circuit structure comprising:
forming circuits on the surface of a semiconductor wafer by photolithographic process; planarizing the surface by chemical mechanical polishing with the composition of one of claims 1 to 15.

18. The process of claim 17 wherein the integrated circuit structure comprises a semiconductor substrate; a ferromagnetic metal layer; a metal selected from the group consisting of group 3d and 5d of the periodic table; a layer of copper or aluminum; a barrier layer; and a dielectric layer.
